# EUROPEAN PATENT APPLICATION

(11) **EP 3 171 391 A1**
(43) Date of publication of application: **24.05.2017**
(21) Application number: 15822179.6
(22) Date of filing: 16.07.2015
(51) Int. Cl.: H01L 21/027, B29C 59/02

(54) **STEP-AND-REPEAT-TYPE IMPRINTING DEVICE AND METHOD**

(30) Priority: 17.07.2014 JP 2014147211
(71) Applicant: Soken Chemical & Engineering Co., Ltd., Toshima-ku Tokyo 171-8531 (JP)
(72) Inventor: MIYAZAWA, Yukihiro, Sayama-shi, Saitama 350-1320 (JP)
(74) Representative: Gulde & Partner
(86) International application number: PCT/JP2015/070365
(87) International publication number: WO 2016/010105

(57) **Abstract**

A step-and-repeat imprinting apparatus is provided that is capable of restraining failures and mold breakage during imprinting. According to the present invention a step-and-repeat imprinting apparatus is provided that includes: a stage to place a stage base; a positioning mechanism configured to be relatively movable to the stage and to keep a flexible base to face the stage base; and a pressurizing mechanism to press, while deflecting the flexible base, the flexible base toward the stage base, wherein one of the stage base and the flexible base has a convex and concave pattern, and another of the stage base and the flexible base includes a transferred resin layer to have the convex and concave pattern transferred thereto, and the apparatus is so configured that the pressurizing mechanism presses, while deflecting, the flexible base toward the stage base, thereby transferring the convex and concave pattern to the transferred resin layer.

## Description

### Technical Field

The present invention relates to an apparatus and a method of step-and-repeat imprinting.

### Background Art

The imprinting technique is a micromachining technique in which a mold having a convex and concave pattern is pressed against a transfer material, such as a liquid resin, on a base, thereby transferring the mold pattern to the transfer material. Such a convex and concave micropattern ranges from patterns at the nanoscale, such as those at the 10 nm level, to patterns at approximately 100 µm. Such a technique is used in various fields, such as semiconductor materials, optical materials, recording media, micromachines, biotechnology, and environmental technology.

Molds having a convex and concave micropattern of nano order on a surface are very expensive because it takes time to form the pattern. Such molds having a convex and concave micropattern of nano order on a surface are thus difficult to be formed in a larger size (larger area).

PTL 1 enables imprinting in a large area by repeated imprinting using a small mold while moving the position of the mold not to overlap processing regions (step-and-repeat).

### Citation List

### Patent Literature

PTL 1: Japanese Patent No. 4262271

### Summary of Invention

### Technical Problem

In the method of PTL 1, a procedure of exposing a transfer material to light while a convex and concave pattern of a mold is vertically pressed against the transfer material for curing to form a cured resin layer having a reverse pattern formed by reversing the convex and concave pattern and then vertically removing the mold from the cured resin layer is repeated.

In the method of PTL 1, when the mold is pressed against the transfer material, air is sometimes sandwiched between them, causing the convex and concave pattern not to be appropriately transferred. High pressure press for removal of air may cause the mold or the base to break. When the mold is removed after formation of the cured resin layer, the reverse pattern formed in the cured resin layer may be damaged. Further, flatness and parallelism of the upper and lower surfaces of the stage to place the base for application of the transfer material greatly affect the transfer accuracy. These problems become severer with an increase in size of the mold.

The present invention has been made in view of such circumstances and is to provide a step-and-repeat imprinting apparatus that is capable of restraining imprinting failures and mold breakage.

### Solution to Problem

According to the present invention a step-and-repeat imprinting apparatus is provided that includes: a stage to place a stage base; a positioning mechanism configured to be relatively movable to the stage and to keep a flexible base to face the stage base; and a pressurizing mechanism to press, while deflecting the flexible base, the flexible base toward the stage base, wherein one of the stage base and the flexible base has a convex and concave pattern, and another of the stage base and the flexible base includes a transferred resin layer to have the convex and concave pattern transferred thereto, and the apparatus is so configured that the pressurizing mechanism presses, while deflecting, the flexible base toward the stage base, thereby transferring the convex and concave pattern to the transferred resin layer.

In the present invention, the convex and concave pattern is transferred by pressing, while deflecting, the flexible base kept by the positioning mechanism relatively movable to the stage against the stage base placed on the stage. Such a configuration facilitates removal of air between the flexible base and the stage base and facilitates separation of them after transfer. Compared with the method of PTL 1, the influence of flatness and parallelism of the upper and lower surfaces is less. Such a configuration facilitates an increase the size of the mold.

Various embodiments of the present invention are disclosed below as examples. The following embodiments may be combined with each other.

Preferably, the pressurizing mechanism is configured to be movable on the flexible base.

Preferably, the positioning mechanism is configured to be movable approximately vertically to a direction of movement of the pressurizing mechanism.

Preferably, the positioning mechanism configured to be movable in a direction approximately identical to a direction of movement of the pressurizing mechanism.

Preferably, the positioning mechanism performs positioning using a fixing mark provided on the stage and a movement mark provided in the positioning mechanism.

Preferably, the fixing mark is multiple squares provided on the stage.

According to another aspect of the present invention, a step-and-repeat imprinting method is provided that includes: transferring, while facing a stage base placed on a stage to a flexible base kept relatively movable to the stage, a convex and concave pattern provided in one of the stage base and the flexible base to a transferred resin layer provided in another of the stage base and the flexible base by pressing the flexible base toward the stage base while deflecting the flexible base; and repeating to perform the transferring step by moving the flexible base.

Preferably, the flexible base is pressed toward the stage base by moving a pressurizing mechanism on the flexible base.

Preferably, the repeating includes moving the flexible base approximately vertically to a direction of movement of the pressurizing mechanism, and performing the transferring.

Preferably, the repeating includes moving the flexible base in a direction approximately identical to a direction of movement of the pressurizing mechanism, and performing the transferring.

### Brief Description of Drawings

Figs. 1A and 1B illustrate a configuration of a step-and-repeat imprinting apparatus in a first embodiment of the present invention, where Fig. 1A is a front view and Fig. 1B is a plan view.
Figs. 2A and 2B are illustrative diagrams of a step-and-repeat imprinting method by the imprinting apparatus in Figs. 1A and 1B, where Fig. 2A is a front view and Fig. 2B is a plan view.
Figs. 3A and 3B are illustrative diagrams of the step-and-repeat imprinting method by the imprinting apparatus in Figs. 1A and 1B, where Fig. 3A is a front view and Fig. 3B is a plan view.
Figs. 4A and 4B are illustrative diagrams of the step-and-repeat imprinting method by the imprinting apparatus in Figs. 1A and 1B, where Fig. 4A is a front view and Fig. 4B is a plan view.
Figs. 5A and 5B are illustrative diagrams of the step-and-repeat imprinting method by the imprinting apparatus in Figs. 1A and 1B, where Fig. 5A is a front view and Fig. 5B is a plan view.
Figs. 6A and 6B illustrate a configuration of a step-and-repeat imprinting apparatus in a second embodiment of the present invention, where Fig. 6A is a front view and Fig. 6B is a plan view.
Figs. 7A and 7B are illustrative diagrams of a step-and-repeat imprinting method by the imprinting apparatus in Figs. 6A and 6B, where Fig. 7A is a front view and Fig. 7B is a plan view.
Figs. 8A and 8B are illustrative diagrams of the step-and-repeat imprinting method by the imprinting apparatus in Figs. 6A and 6B, where Fig. 8A is a front view and Fig. 8B is a plan view.
Figs. 9A and 9B are illustrative diagrams of the step-and-repeat imprinting method by the imprinting apparatus in Figs. 6A and 6B, where Fig. 9A is a front view and Fig. 9B is a plan view.
Figs. 10A and 10B illustrate a configuration of a step-and-repeat imprinting apparatus in a third embodiment of the present invention, where Fig. 10A is a front view and Fig. 10B is a plan view.
Figs. 11A and 11B are illustrative diagrams of a positioning method by the imprinting apparatus in Figs. 10A and 10B, where Fig. 11A is a front view and Fig. 11B is a plan view.
Figs. 12A toh 12F illustrate images taken by imaging units 37a and 37b in the state of Figs. 11A and 11B, where Fig. 12A and Fig. 12B illustrate the state before correction, Fig. 12C and Fig. 12D illustrate the state after tilt correction, and Fig. 12E and Fig. 12F illustrate the state after longitudinal position correction.

### Description of Embodiments

Preferred embodiments of the present invention are specifically described below with reference to the drawings.

### 1. First Embodiment

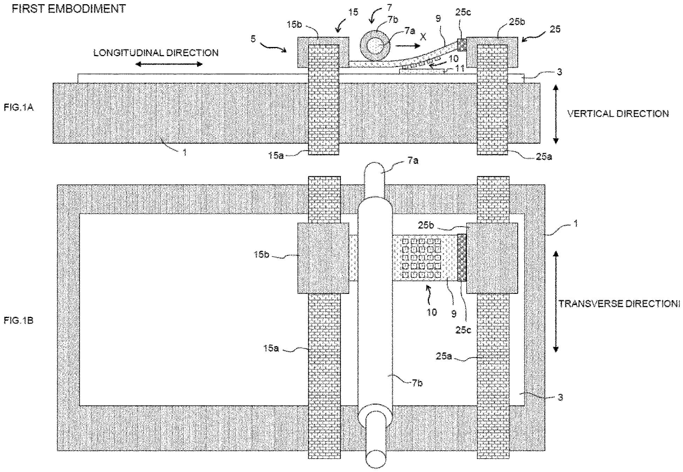

As illustrated in Figs. 1A and 1B, a step-and-repeat imprinting apparatus in the first embodiment of the present invention includes a stage 1 to place a stage base 3, a positioning mechanism 5 configured to be relatively movable to the stage 1 and to keep a flexible base 9 to face the stage base 3, and a pressurizing mechanism 7 to press, while deflecting the flexible base 9, the flexible base 9 toward the stage base 3.

In the present embodiment, a partial region of the flexible base 9 is provided with a convex and concave pattern 10, and the stage base 3 is formed with a transferred resin layer 11 to have the convex and concave pattern 10 transferred thereto. Then, the pressurizing mechanism 7 is configured to press, while deflecting, the flexible base 9 toward the stage base 3, thereby transferring the convex and concave pattern 10 to the transferred resin layer 11. Accordingly, the flexible base 9 having the convex and concave pattern 10 functions as an imprinting mold.

More specifically, the positioning mechanism 5 includes a rear end holding unit 15 to keep a rear end side of the flexible base 9 and a front end holding unit 25 to keep a front end side of the flexible base 9. The rear end holding unit 15 includes a longitudinal driving unit 15a configured to be movable in a longitudinal direction of the stage 1 and a transverse driving unit 15b supported by the longitudinal driving unit 15a and configured to be movable in a transverse direction of the stage 1. The front end holding unit 25 includes a longitudinal driving unit 25a configured to be movable in the longitudinal direction of the stage 1, a transverse driving unit 25b supported by the longitudinal driving unit 25a and configured to be movable in the transverse direction of the stage 1, and a vertical driving unit 25c supported by the transverse driving unit 25b and configured to be movable in a vertical direction of the stage 1. The rear end side of the flexible base 9 is two dimensionally movable over the stage 1 by being supported by the transverse driving unit 15b. The front end side of the flexible base 9 is three dimensionally movable over the stage 1 by being supported by the vertical driving unit 25c. The configuration of the positioning mechanism 5 is not limited to those described here and various configurations are applicable. For example, the rear end holding unit 15 may be provided with a vertical driving unit to support the rear end side of the flexible base 9 by the vertical driving unit. In this case, the rear end side of the flexible base 9 also becomes three dimensionally movable over the stage 1 and thus the gap between the flexible base 9 and the stage base 3 is more readily adjusted. For step-and-repeat only in the transverse direction, the longitudinal driving units 15a and 25a do not have to be provided.

The pressurizing mechanism 7 is configured with a column roller 7b rotatable on the rotation shaft 7a. The rotation shaft 7a is supported by bearings of a support mechanism, not shown, movable in the longitudinal direction of the stage 1. Such a configuration causes the roller 7b to move on the flexible base 9 while rotating on the flexible base 9, thereby enabling pressing of the flexible base 9 against the stage base 3. The pressurizing mechanism 7 only has to press, while deflecting, the flexible base 9 toward the stage base 3, and thus the roller 7b does not have to rotate. The pressurizing mechanism 7 may be configured to move a blade in a plate shape instead of the roller 7b. Moreover, the pressurizing mechanism 7 may be configured to press, while deflecting, the flexible base 9 without moving. Further, if the pressurizing mechanism 7 presses, while deflecting, the flexible base 9 using a gas, such as air, toward the stage base 3, it does not have to contact the flexible base 9 with the pressurizing mechanism 7.

Here, using the imprinting apparatus in the present embodiment, a method of step-and-repeat imprinting is described.

First, as illustrated in Figs. 1A and 1B, the stage base 3 is placed on the stage 1 and the transferred resin layer 11 is formed on the stage base 3. The flexible base 9 having the convex and concave pattern 10 is attached to the positioning mechanism 5.

The stage base 3 may or may not be flexible and may or may not be transparent. To the stage base 3, various bases such as resin bases, quartz bases, silicone bases, and silicon bases are applicable.

The transferred resin layer 11 is formed by applying a photocurable resin composition on the stage base 3. Such a photocurable resin composition contains a monomer and a photoinitiator and has properties to be cured by irradiation with an activation energy line. "The activation energy line" is the generic name for energy lines capable of curing a photocurable resin composition, such as UV light, visible light, and electron beams. The transferred resin layer 11 is generally a transparent resin layer and generally has a thickness from 50 nm to 1 mm and preferably from 500 nm to 500 µm. A thickness in this range facilitates imprinting. In the present embodiment, every time imprinting is performed, a transferred resin layer 11 is formed in a region for the next imprinting. That is, imprinting and formation of the transferred resin layer 11 is alternately performed. The method is not limited to this embodiment, and the transferred resin layer 11 may be formed in the entire region for imprinting at first or the transferred resin layer 11 may be formed at once in a region equivalent to a plurality of imprinting procedures to reduce the number of the transferred resin layer 11 formation steps.

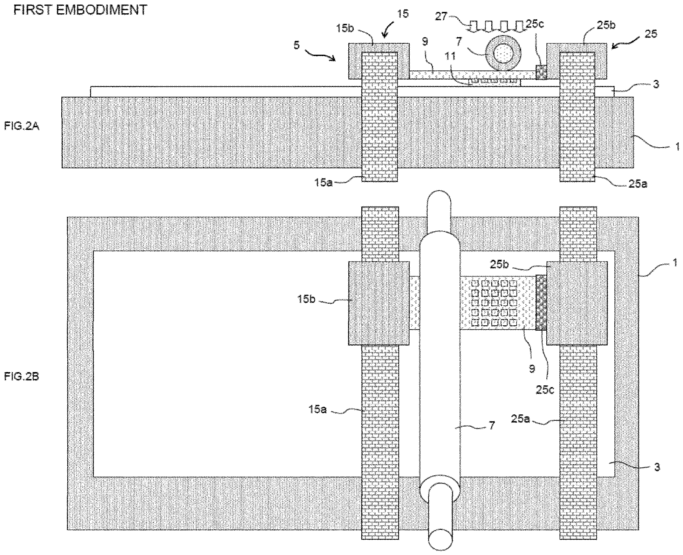

The flexible base 9 is a base has flexibility. The transferred resin layer 11 is generally irradiated with activation energy lines 27 (see Figs. 2A and 2B) through the flexible base 9, and thus the flexible base 9 is preferably transparent. The flexible base 9 is, for example, a resin base. Examples of an applicable resin include polyethylene terephthalate, polycarbonate, polyester, polyolefin, polyimide, polysulfone, polyether sulfone, cyclic polyolefin, polyethylene naphthalate, and the like.

The convex and concave pattern 10 is formed on a resin layer formed by applying a thermoplastic resin, a thermosetting resin, or a photocurable resin on the flexible base 9. The resin to be applied is preferably a photocurable resin. Specific examples include an acrylic resin, a styrene resin, an olefin resin, a polycarbonate resin, a polyester resin, an epoxy resin, a silicone resin, and the like. The resin may contain a peeling component, such as a fluorine compound, a long chain alkyl compound, and wax. The convex and concave pattern 10 is not particularly limited, and preferably has intervals from 10 nm to 2 mm, a depth from 10 nm to 500 µm, and a transfer surface from 1.0 to 1.0 × 10⁶ mm², and more preferably intervals from 20 nm to 20 µm, a depth from 50 nm to 1 µm, and a transfer surface from 1.0 to 0.25 × 10⁶ mm². Such settings enable sufficient transfer of the convex and concave pattern 10 to a transfer body. Examples of the surface shape include moth eye patterns, lines, columns, monoliths, cones, polygonal pyramids, and microlens arrays.

Next, the positioning mechanism 5 and the pressurizing mechanism 7 are moved to the positions illustrated in Figs. 1A and 1B. The pressurizing mechanism 7 is located in a position close to the rear end holding unit 15, and the vertical driving unit 25c of the front end holding unit 25 is in a relatively high position. In this state, the flexible base 9 is deflected. The pressurizing mechanism 7 is not positioned above the transferred resin layer 11 and the convex and concave pattern 10 is not transferred to the transferred resin layer 11.

Then, from the state in Figs. 1A and 1B, the pressurizing mechanism 7 is moved in a direction indicated by an arrow X in Figs. 1A and 1B and the vertical driving unit 25c is lowered to be brought into the state illustrated in Figs. 2A and 2B. At this point, an end of the convex and concave pattern 10 makes contact with the transferred resin layer 11 at first. With the lowering of the vertical driving unit 25c and the movement of the pressurizing mechanism 7, the convex and concave pattern 10 is pressed against the transferred resin layer 11 while a contact area of the convex and concave pattern 10 and the transferred resin layer 11 gradually increases, and finally, the entire convex and concave pattern 10 is transferred to the transferred resin layer 11. According to such a transfer method, air is well removed and high pressure press does not have to be carried out. In addition, the flatness and parallelism of the upper and lower surfaces of the stage 1 do not affect much.

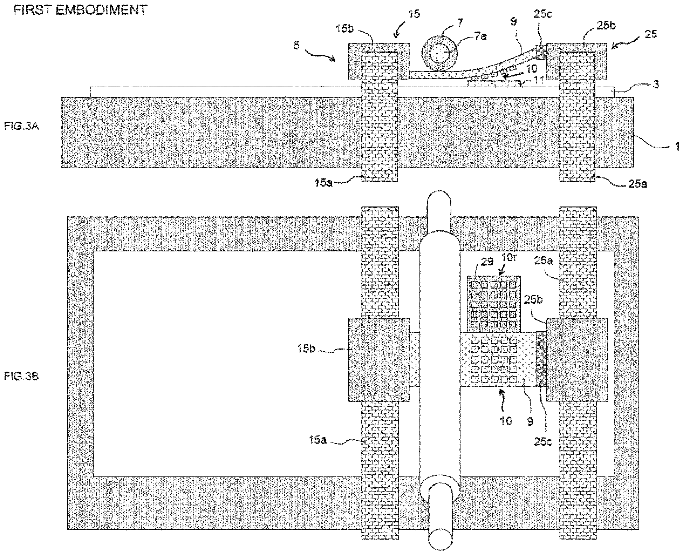

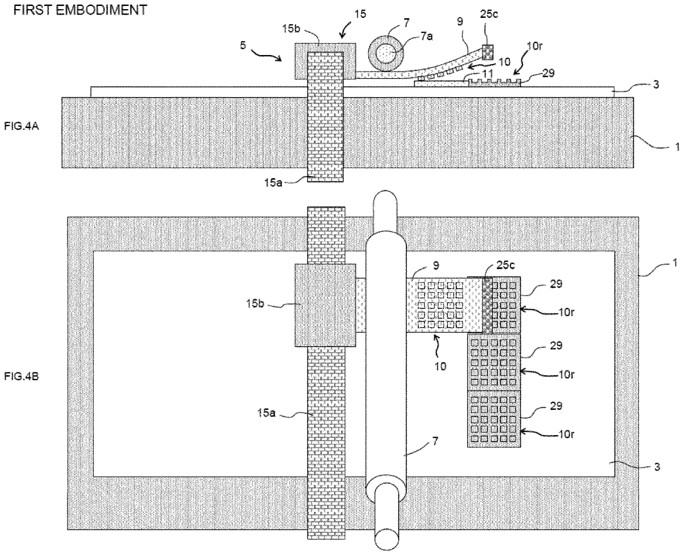

Then, as illustrated in Figs. 2A and 2B, while the convex and concave pattern 10 is pressed against the transferred resin layer 11, the transferred resin layer 11 is irradiated with the activation energy lines 27 through the flexible base 9 to cure the transferred resin layer 11. As illustrated in Figs. 3B, 4A and 4B, a cured resin layer 29 having a reverse pattern 10r formed by reversing the convex and concave pattern 10 is thus formed. If the pressurizing mechanism 7 is transparent, as Figs. 2A and 2B, irradiation with the activation energy lines 27 can be carried out while locating the pressurizing mechanism 7 over the transferred resin layer 10. Meanwhile, as illustrated in Figs. 1A and 1B, the irradiation with the activation energy lines 27 may be carried out by putting back the pressurizing mechanism 7 in a position close to the rear end holding unit 15.

Then, if the pressurizing mechanism 7 is over the transferred resin layer 11, the pressurizing mechanism 7 is put back in a position close to the rear end holding unit 15 to raise the vertical driving unit 25c, thereby peeling the convex and concave pattern 10 from the cured resin layer 29. At this point, while the flexible base 9 is deflected, the peeling gradually proceeds from an end of the convex and concave pattern 10. The force for peeling is thus relatively small and a risk of damaging the convex and concave pattern 10 and the reverse pattern 10r is reduced.

Then, as illustrated in Figs. 3A and 3B, the transverse driving units 15b and 25b are moved for one step in the transverse direction of the stage 1 to form a cured resin layer 29 having the reverse pattern 10r in the same manner.

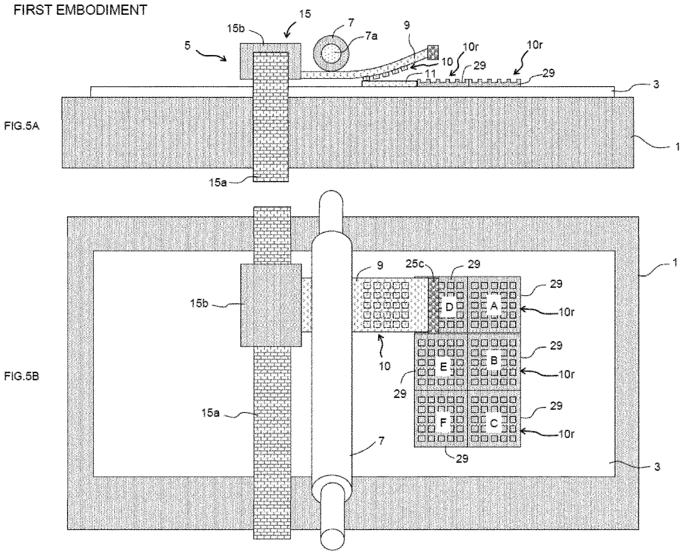

After completion of step-and-repeat in the transverse direction, as illustrated in Figs. 4A and 4B through Figs. 5A and 5B, the longitudinal driving units 15a and 25a are moved for one step in the longitudinal direction of the stage 1 to form a cured resin layer 29 having the reverse pattern 10r in the same manner. For the convenience of the illustration, Figs. 4A and 4B through Figs. 5A and 5B do not illustrate the longitudinal driving unit 25a and the transverse driving unit 25b.

By repeating the above procedure, a microstructure formed with the reverse pattern 10r of a desired area on the stage base 3 is formed. Such a microstructure is applicable to imprinting molds, stampers for microcontact printing, optical sheets (antireflective sheets, hologram sheets, lens sheets, and polarization separation sheets), water repellent sheets, hydrophilic sheets, cell culture sheets, and the like.

The order of step-and-repeat is not particularly limited and examples of the order include the order of A, B, C, D, E, and F in Figs. 5A and 5B, the order of A, B, C, F, E, and D, the order of A, C, B, D, F, and E, and the like.

### 2. Second Embodiment

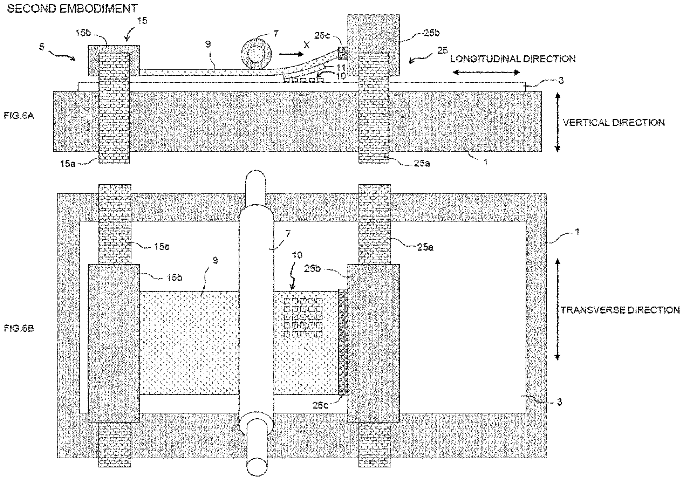

In the first embodiment, the flexible base 9 is provided with the convex and concave pattern 10, and the stage base 3 is provided with the transferred resin layer 11. In the present embodiment, as illustrated in Figs. 6A and 6B, the flexible base 9 is provided with the transferred resin layer 11 and the stage base 3 is provided with the convex and concave pattern 10 for step-and-repeat imprinting while the flexible base 9 is moved. Accordingly, the stage base 3 having the convex and concave pattern 10 functions as an imprinting mold.

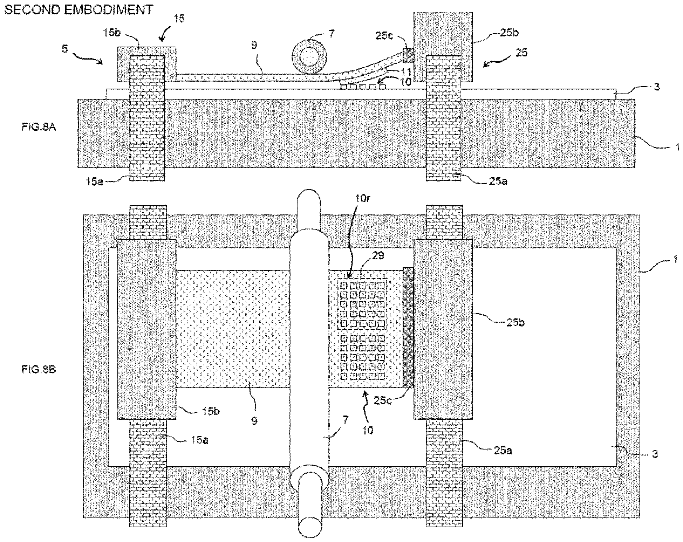

The imprinting apparatus in the present embodiment has the same basic configuration as that in the first embodiment, and the descriptions in common are omitted. In the present embodiment, a micropattern in a large area is formed in the flexible base 9 by step-and-repeat imprinting, so that the flexible base 9 has to be larger than that in the first embodiment. In proportion to the increase in size of the flexible base 9, the transverse driving unit 15b and the vertical driving unit 25c, keeping the base 9, are made larger. As illustrated in Figs. 8A and 8B, the vertical driving unit 25c has a range of motion greater than that in the first embodiment to enable deflection of the flexible base 9 even when the position of the transferred resin layer 11 on the flexible base 9 is relatively apart from the vertical driving unit 25c.

Here, a method of step-and-repeat imprinting using the imprinting apparatus in the present embodiment is described.

First, as illustrated in Figs. 6A and 6B, the stage base 3 having the convex and concave pattern 10 is placed on the stage 1. The flexible base 9 is attached to the positioning mechanism 5, and the transferred resin layer 11 is formed on the flexible base 9.

Next, the positioning mechanism 5 and the pressurizing mechanism 7 are moved in a position illustrated in Figs. 6A and 6B. The pressurizing mechanism 7 is located in a position closer to the rear end holding unit 15 than right above the transferred resin layer 11, and the vertical driving unit 25c of the front end holding unit 25 is in a relatively high position. In this state, the flexible base 9 is deflected. The pressurizing mechanism 7 is not positioned above the transferred resin layer 11 and the convex and concave pattern 10 is not transferred to the transferred resin layer 11.

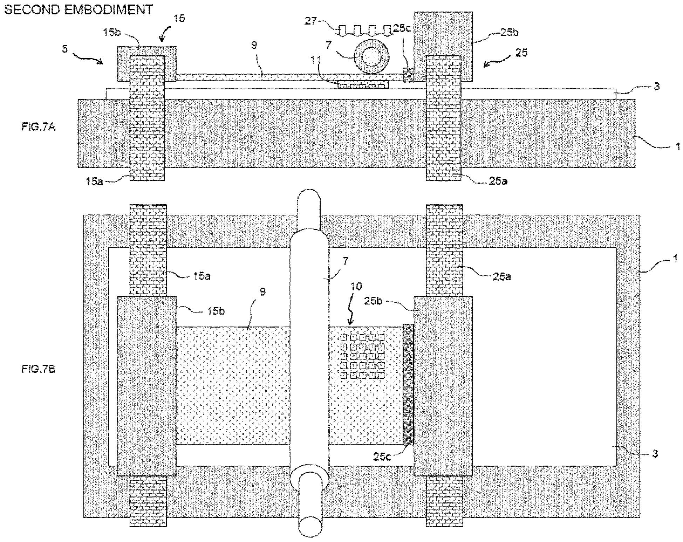

Then, from the state in Figs. 6A and 6B, the pressurizing mechanism 7 is moved in a direction indicated by an arrow X in Figs. 6A and 6B and the vertical driving unit 25c is lowered to be brought into the state illustrated in Figs. 7A and 7B. At this point, an end of the convex and concave pattern 10 makes contact with the transferred resin layer 11 at first. With the lowering of the vertical driving unit 25c and the movement of the pressurizing mechanism 7, the convex and concave pattern 10 is pressed against the transferred resin layer 11 while a contact area of the convex and concave pattern 10 and the transferred resin layer 11 gradually increases, and finally, the entire convex and concave pattern 10 is transferred to the transferred resin layer 11. According to such a transfer method, air is well removed and high pressure press does not have to be carried out. In addition, the flatness and parallelism of the upper and lower surfaces of the stage 1 do not affect much.

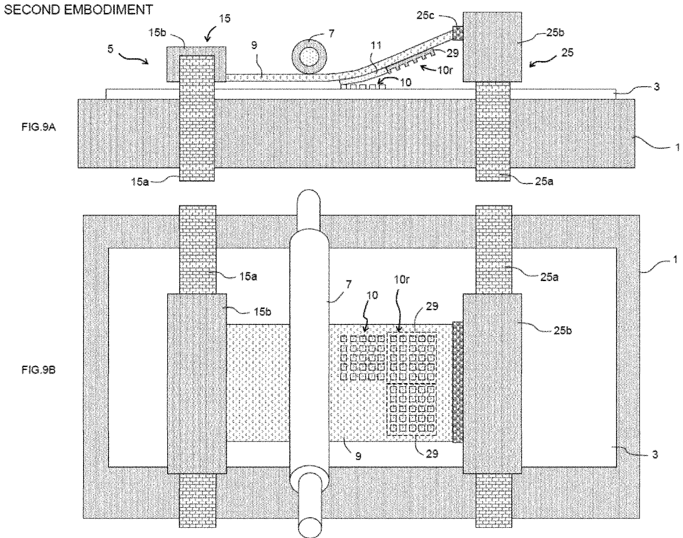

Then, as illustrated in Figs. 7A and 7B, while the convex and concave pattern 10 is pressed against the transferred resin layer 11, the transferred resin layer 11 is irradiated with the activation energy lines 27 through the flexible base 9 to cure the transferred resin layer 11. As illustrated in Figs. 8B, 9A and 9B, the cured resin layer 29 having the reverse pattern 10r formed by reversing the convex and concave pattern 10 is formed.

Then, if the pressurizing mechanism 7 is over the transferred resin layer 11, the pressurizing mechanism 7 is put back in a position close to the rear end holding unit 15 to raise the vertical driving unit 25c, thereby peeling the convex and concave pattern 10 from the cured resin layer 29. At this point, while the flexible base 9 is deflected, the peeling gradually proceeds from an end of the convex and concave pattern 10. The force for peeling is thus relatively small and a risk of damaging the convex and concave pattern 10 and the reverse pattern 10r is reduced.

Then, as illustrated in Figs. 8A and 8B, the transverse driving units 15b and 25b are moved for one step in the transverse direction of the stage 1 to form a cured resin layer 29 having the reverse pattern 10r in the same manner.

After completion of step-and-repeat in the transverse direction, as illustrated in Figs. 9A and 9B, the longitudinal driving units 15a and 25a are moved for one step in the longitudinal direction of the stage 1 to form a cured resin layer 29 having the reverse pattern 10r in the same manner. By repeating the above procedure, a microstructure formed with the reverse pattern 10r of a desired area on the flexible base 9 is formed.

### 3. Third Embodiment

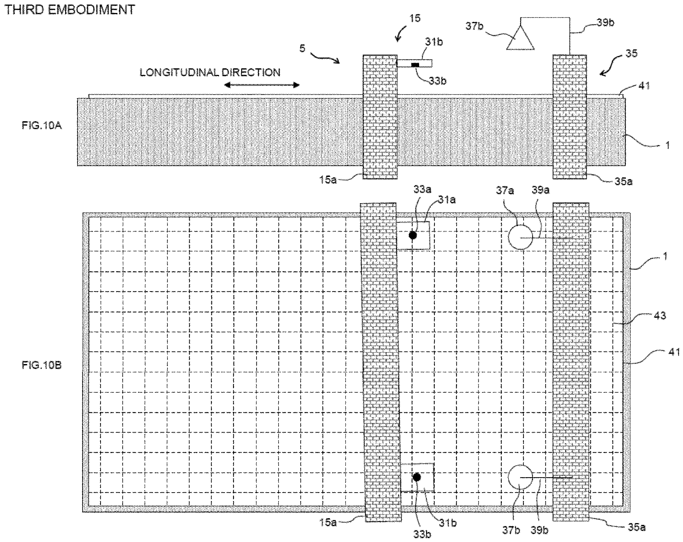

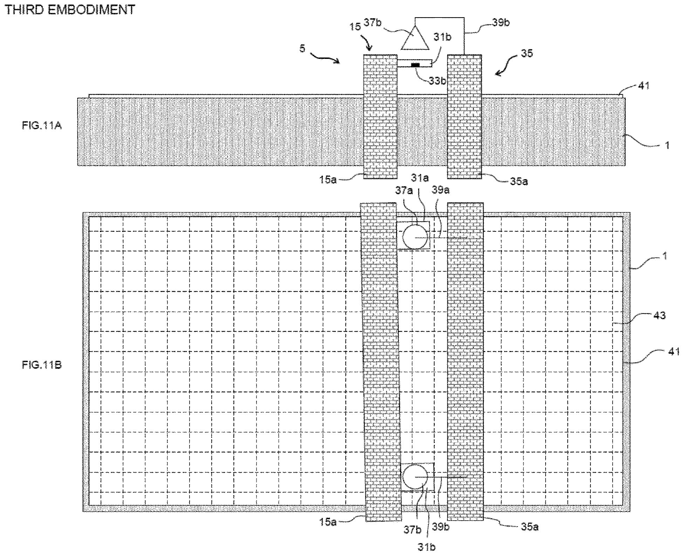

In the first and second embodiments, the position accuracy for movement of each driving unit of the rear end holding unit 15 and the front end holding unit 25 is dependent on the accuracy of a driving mechanism, such as screw feeding, whereas there is a problem that driving mechanisms with high accuracy are very expensive. The present embodiment is characterized by enabling high accuracy positioning relatively inexpensively. The present embodiment is applicable to the first and second embodiments and the descriptions in common are not repeated. Further, Figs. 10A and 10B through Figs. 11A and 11B illustrate only the areas necessary for description of the present embodiment.

In the present embodiment, a precision scale 41 is placed on the stage 1. On the precision scale 41, multiple squares 43 are drawn with high accuracy of dimension. The stage base 3 in the first and second embodiments is placed on the precision scale 41. A transparent base is used as the stage base 3, and the squares 43 are observable through the stage base 3. The squares 43 are immobile during the positioning of the positioning mechanism 5 and function as the "fixing mark" in the scope of claims.

The longitudinal driving unit 15a of the front end holding unit 15 has approximately both ends provided with transparent plates 31a and 31b having marks 33a and 33b. The marks 33a and 33b are marks that are moved during positioning of the positioning mechanism 5 and function as the "movement mark" in the scope of claims.

The stage 1 is provided with an imaging mechanism 35. The imaging mechanism 35 includes a longitudinal driving unit 35a. The longitudinal driving unit 35a includes imaging units 37a and 37b supported by supporting units 39a and 39b. The imaging units 37a and 37b are configured with a microscope and the like.

Then, a method of positioning with high accuracy using the squares 43 and the marks 33a and 33b is described. Here, positioning of the longitudinal driving unit 15a is described in detail while the same method is applicable to other driving units.

First, the longitudinal driving unit 15a is moved to a desired position in the longitudinal direction of the stage 1. Figs. 10A and 10B illustrate an example of a state after movement.

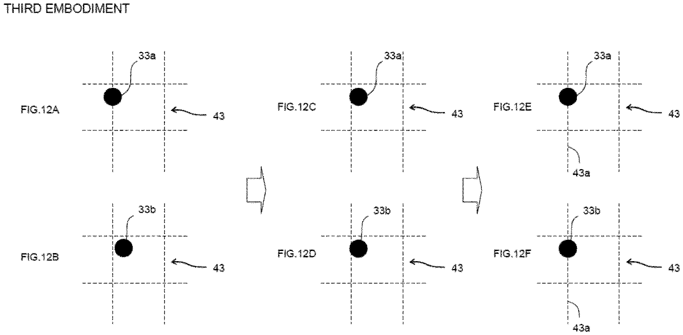

Next, the longitudinal driving unit 35a is moved to position the imaging units 37a and 37b right above the marks 33a and 33b, and the marks 33a and 33b and the squares 43 are imaged from right above the marks 33a and 33b. Figs. 12A and 12B illustrate an example of the images thus obtained. In this example, the mark 33a is positioned on the left from the mark 33b and the longitudinal driving unit 15a is slightly tilted to the left.

Then, as illustrated in Figs. 12C and 12D, the longitudinal driving unit 15a is rotated clockwise until the left and right positions of the marks 33a and 33b match.

Then, as illustrated in Figs. 12E and 12F, the longitudinal driving unit 15a is moved to position the marks 33a and 33b on vertical lines 43a of the squares 43 to complete positioning of the longitudinal driving unit 15a. According to such a method, even if the longitudinal driving unit 15a has the driving mechanism with low accuracy, use of the precision scale 41 with high accuracy enables positioning of the longitudinal driving unit 15a with high accuracy. In the present embodiment, the two marks 33a and 33b are used to correct the tilt of the longitudinal driving unit 15a as well, whereas one mark may be used for positioning of the longitudinal driving unit 15a to omit the tilt correction. In addition, the transverse driving unit 15b may be provided with similar marks to allow positioning of the transverse driving unit 15b with high accuracy. The fixing mark and the movement mark are not limited in their shapes as long as they allow positioning of the positioning mechanism 5.

### Reference Signs List

1: Stage, 3: Stage Base, 5: A Positioning Mechanism, 7: Pressurizing Mechanism, 9: Flexible Base, 10: Convex and Concave Pattern, 10r: Reverse Pattern, 11: Transferred Resin Layer, 15: Rear End Holding Unit, 25: Front End Holding Unit, 29: Cured Resin Layer, 35: Imaging Mechanism

## Claims

1. A step-and-repeat imprinting apparatus, comprising:
a stage to place a stage base;
a positioning mechanism configured to be relatively movable to the stage and to keep a flexible base to face the stage base; and
a pressurizing mechanism to press, while deflecting the flexible base, the flexible base toward the stage base, wherein
one of the stage base and the flexible base has a convex and concave pattern, and another of the stage base and the flexible base includes a transferred resin layer to have the convex and concave pattern transferred thereto, and
the apparatus is so configured that the pressurizing mechanism presses, while deflecting, the flexible base toward the stage base, thereby transferring the convex and concave pattern to the transferred resin layer.

2. The apparatus of Claim 1, wherein the pressurizing mechanism is configured to be movable on the flexible base.

3. The apparatus of Claim 2, wherein the positioning mechanism is configured to be movable approximately vertically to a direction of movement of the pressurizing mechanism.

4. The apparatus of Claim 2 or 3, wherein the positioning mechanism configured to be movable in a direction approximately identical to a direction of movement of the pressurizing mechanism.

5. The apparatus of any one of Claims 1 to 4, wherein the positioning mechanism performs positioning using a fixing mark provided on the stage and a movement mark provided in the positioning mechanism.

6. The apparatus of Claim 5, wherein the fixing mark is multiple squares provided on the stage.

7. A step-and-repeat imprinting method, comprising:
transferring, while facing a stage base placed on a stage to a flexible base kept relatively movable to the stage, a convex and concave pattern provided in one of the stage base and the flexible base to a transferred resin layer provided in another of the stage base and the flexible base by pressing the flexible base toward the stage base while deflecting the flexible base; and
repeating to perform the transferring step by moving the flexible base.

8. The method of Claim 7, wherein the flexible base is pressed toward the stage base by moving a pressurizing mechanism on the flexible base.

9. The method of Claim 8, wherein the repeating includes moving the flexible base approximately vertically to a direction of movement of the pressurizing mechanism, and performing the transferring.

10. The method of Claim 8 or 9, wherein the repeating includes moving the flexible base in a direction approximately identical to a direction of movement of the pressurizing mechanism, and performing the transferring.
